# EUROPEAN PATENT SPECIFICATION

(11) **EP 0 359 221 B1**
(45) Date of publication and mention of the grant of the patent: **15.05.1996**
(21) Application number: 89116936.9
(22) Date of filing: 13.09.1989
(51) Int. Cl.: G03F 7/38, H01L 21/00

(54) **High pressure photoresist silylating process and apparatus**
Hochdruck-Photolack Siliconisierungsverfahren und Vorrichtung
Procédé pour traiter à haute pression au silicone des résines photosensibles et appareil

(30) Priority: 16.09.1988 US 245878; 31.10.1988 US 265205
(43) Date of publication of application: 21.03.1990
(73) Proprietor: TEXAS INSTRUMENTS INCORPORATED, Dallas Texas 75265 (US)
(72) Inventor: Davis, Cecil J., Greenville Texas 75401 (US); Misium, George R., Richardson Texas 75081 (US); Garza, Cesar M., Plano Texas 75023 (US)
(74) Representative: Leiser, Gottfried, Dipl.-Ing.

(56) References cited:
- EP-A- 0 209 150
- EP-A- 0 227 561
- EP-A- 0 244 951
- WO-A-87/06561
- US-A- 4 768 291

## Description

### BACKGROUND OF THE INVENTION

### 1. Field of the Invention

The present invention relates to a method and apparatus for manufacturing integrated circuits and other electronic devices. More particularly, the invention relates to an improved method and apparatus for silylation of photoresist in the manufacturing of integrated circuits and other electronic devices.

### 2. Description of the Related Art

Integrated circuit dimensions continue to be reduced due to various factors, such as cost per unit function considerations, faster required switching speeds, and desire for lower power consumption. Optical lithographic limitations are currently one of the major factors limiting size reduction in integrated circuit fabrication. Current projections forecast the lower limit of optical photolithography techniques currently under consideration to be less than .5 microns. However these techniques require further development to allow submicron fabrication using optical photolithography to be effectively transferred ffom the design laboratory to production fabrication facilities.

The optical lithographic processes of the prior art have several limitations which have heretofore blocked significant reduction in feature sizing in integrated circuit production. Examples of these limitations are described following. Optical lithographic apparatuses have physically limited depths of field, maluug it difficult or impossible to expose a thick photosensitive material through its thickness or to expose a layer of photosensitive material accurately which is not topographically planar at its surface. Depth of field is reduced as equipment is configured for smaller and smaller feature size. Wet etching and treating processes usually cause swelling of the remaining photosensitive material and other materials. Such swelling becomes more significant as feature size becomes smaller and prevents achievement of acceptable line to space ratios in some cases. Reflectivity of layer interfaces due to differing reffactive indices of the materials causes diffusion and back scattering of the exposing radiation.

Efforts to overcome the limitations of standard optical lithographic equipment and techniques have been numerous and at least somewhat successful and continue to be a major thrust of semiconductor processing research. Multiple layer masks resulting in a thin planar photosensitive surface layer to be optically exposed, various exposure radiation sources and distances, closer tolerance optical equipment, and, in general, optimization of all process parameters relative to each other in the optical lithographic process have all contributed to reducing the minimum feature size possible in integrated circuit production. All of these approaches continue to be studied. However, there continues to be a need for further size reduction and, concurrently, avoidance of the more complicated and costly process steps necessary in some of the techniques to reduce sizing.

A promising development in the continued research to reduce obtainable sizing in optical lithography is advanced by B. Roland and A. Vrancken in "Method for the Preparation of Negative Patterns in a Layer of Photosensitive Resist", European Patent Number 184,567 A1, filed October 24, 1985, "Method for Producing Positive Patterns in a Photoresist Layer," European Patent Number 248,779 A1, published September 12, 1987, and further discussed in "DESIRE: A Novel Dry Developed Resist System", F. Coppmans et al., Advances in Resist Technology and Processing III, SPIE Proceedings, Vol. 631 (1986). This development followed closely the more general concepts advanced by G. N. Taylor, et al., in "Gas-Phase-Functionalized Plasma-Developed Resists: Initial Concepts and Results for Electron-Beam Exposure", Journal of the Electrochemical Society, Vol. 131, No. 7 (July 1984). U.S. Patent Application Serial No. 216,884, filed July 8, 1988, discloses a method and an apparatus for low pressure silylation and etching of semiconductor wafers. "DESIRE: A New Approach for Silicon Incorporation in Dry Developed Photoresists by B. Roland, R. Lomberts, and F. Coopmans, 1986 Dry Process Symposium Proceedings, p. 98, discusses surface-sensitive processes, where only the surface of the resist needs to be exposed to offer the performance advantages of multilayer schemes with the simplicity of single layer processing. These references, to the extent allowable, are incorporated herein by reference. This technique, as has been developed, is described generally in the following paragraphs.

The process generally consists of coating a substrate with a layer of photosensitive resin containing a polymer, preferably a phenolic polymer mixed with or bound to a photosensitive compound such as diazoquinone, exposure of this layer to visible or ultraviolet light through a mask, treating of the exposed layer to a silicon containing compound such as hexamethyldisilane in gas state although a liquid state treatment is possible, and then dry etching of the layer with a plasma such as by an oxygen plasma etch. The silylation is described as being accomplished in a chamber at reduced pressure generally with the substrate and resist layer being heated to a relatively high temperature. The extent of silylation is generally controlled by the length of time exposed to the silylating agent. As pointed out by Roland and Coppmans in the references above, the treatment of the photosensitive layer after exposure results in silylation of the exposed (unmasked) areas of the photosensitive layer with little or no silylation of the unexposed (masked) areas for negative pattern photosensitive resists or, alternatively, heavy silylation of the unexposed areas with little or no silylation of the exposed areas for a positive pattern photosensitive resist. Further, discussion will exemplify the use of the negative pattern photosensitive resist,however, it will be understood that the inventive process and apparatus apply equally to both. Silylation, as defined in Silylation of Organic Compounds, by A. Pierce, Pierce Chemical Company, pages 1-3, and further explored in "Mechanism and Kinetics of Silylation of Resist Layers from the Gas Phase", R. Visser, et al., SPIE, Vol. 87, is the introduction of of the silyl group (generally -Si(CH3)3) into a molecule, generally by replacement of a hydrogen. In the case of silylation of a resist layer, the silylating agent diffuses into and reacts with the exposed resin of the resist layer according to the generalized formula:

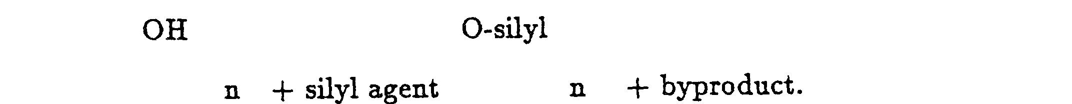

The kinetics of the reaction, particularly the rate of diffusion, cause the silylation to be highly selective to the exposed areas of the photoresist and to be restricted to only the near surface of the resist layer, e.g., the top 100 to 1000 nm (1000 to 10,000 Angstroms). Deeper exposures of the photoresist layer may be limited by techniques such as dying of the photoresist material. An anisotropic plasma etch, particularly an oxygen plasma etch, causes the incorporated silicon to form silicon dioxide which acts as an in-situ mask for the etch, oxygen plasma etching being highly selective to the silicon dioxide compared to the remainder of the resist.

This process presents several advantages for optical lithography. Since the silylation is restricted to only the topmost portion of the resist layer, exposure depth may be restricted to only that depth or, in any case, deeper exposure which may not be accurately focused becomes less important. This greatly reduces depth of field problems and the problems associated with diffusion of the exposure radiation. A dry etching process may be used to develop the resist layer because of the high selectivity of a plasma etch to the silylated regions. Therefore the problems caused by wet etching techniques are eliminated. Because the silylation is highly selective to the exposed versus unexposed portions of the resist layer, acceptably precise mask layers may be produced from the resist layer.

There are, however, problems associated with the above described process. Exposure of the resist layer to the silylating agent is described in the references as being accomplished at high temperatures and for relatively long time periods, especially if the temperature is not high. Control of the extent of silylation has been difficult. Silylation has been described in the literature as being accomplished at low pressures, requiring vacuum or low pressure processing receptacles.

If the silylation step could be performed in a high pressure environment in conjunction with a sequential vacuum processing steps, more rapid silylation, lower particle contamination, and increased process efficiency could be achieved. This in turn would improve the yield, and increase throughput. Furthermore, in low volume production of application specific devices, higher equipment utilization can be achieved reducing initial capital requirements.

### SUMMARY OF THE INVENTION

The invention contemplates silylation of a photoresist layer as set forth in claim 1. After exposure of the layer through a mask by radiation a silylating agent is introduced to the layer under pressure of at least one atmosphere or higher and the temperature of the resist layer (and the substrate thereunder) is reduced to less than 180 degrees C.

An apparatus suitable for silylating an exposed resist layer on a semiconductor substrate comprises: a process chamber having an port and a process gas inlet; a heated substrate in the process chamber; a loadlock in fluid communication with the process chamber through the port; and a gas generator in fluid communication with the process chamber through the gas inlet.

The described apparatus can, if necessary, introduce a silylating agent and an inert pressurizing agent under pressure to the chamber and maintain a pressure of one atmosphere or higher in the chamber.

The described apparatus can also be used in conjunction with process chambers attached to a central transfer module for transferring the workpiece under a vacuum. It can also be used in conjunction with separated chambers where the workpiece is transferred in a vacuum wafer carrier between them.

It has also been found useful to transfer and develop the wafer in a face down configuration and under a vacuum, but this module can be used for wafer not carried in a vacuum wafer carrier.

It has been discovered that for a given temperature, the time to reach a desired level of silylation of the exposed photoresist is reduced.

It has been discovered that the process may be undertaken at lower temperatures by increasing the pressure under which the silylating agent is introduced to the resist.

It has been discovered that the processing parameters of time and temperature may be effectively more controllable and therefore the extent of silylation more controllable by utilizing a high pressure silylating apparatus.

These and other advantages of the inventive process and apparatus will become evident from the following drawing figures and detailed description of the invention.

### BRIEF DESCRIPTION OF THE DRAWINGS

The present invention will be described with reference to the accompanying drawings, wherein:

Figures 1A-1C are schematic drawings of the optical lithographic process according to the prior art.

Figure 2 is a block diagram of an embodiment of the silylating apparatus of the invention.

Figure 3 is a schematic diagram of an embodiment of the silylating apparatus of the invention.

In this figure, like reference numerals are used to denote like or similar parts. Additionally, in the drawings, the sizes and dimensions of the various parts have been exaggerated or distorted for clarity of illustration and ease of description.

Figure 4 is a graph of experimental results of the process of the invention plotting linewidth vs. pressure.

Figure 5 is a graph of the experimental results of the process of the invention plotting resist thickness of silylation vs. pressure.

### DETAILED DESCRIPTION OF THE PREFERRED EMBODIMENT OF THE INVENTION

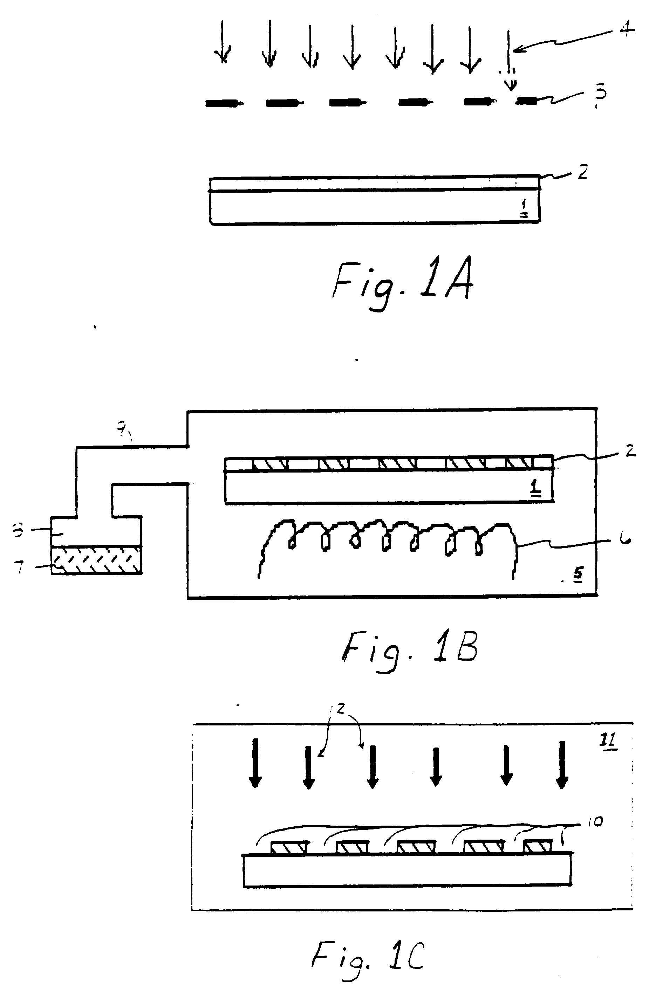

The optical lithography process of the prior art will be described with respect to Figures 1A- 1C. A semiconductor wafer substrate 1 with photosensitive resist layer 2 is exposed through mask 3 by radiation 4 generally radiated in an orthogonal direction relative to the surface of resist layer 2. The substrate 1 may be a semiconductor wafer, e.g. single crystal silicon, during any stage of processing requiring a lithography step. The substrate 1 therefore may contain implanted active and passive devices (not shown), devices formed on the semiconductor, one or more conductive layers and one or more insulating layers. The photosensitive resist layer may be any mixture or compound which is photosensitive and is capable of being silylated. Preferably the resist layer is a phenolic polymer combined with a photosensitive compound, such as diazoquinone. The photosensitive resist layer is applied and cured in a manner known in the art. Mask 3 as is well known in the art is an image forming mask, transparent to exposing radiation in selected areas and blocking the exposing radiation in the remaining areas. Radiation 4 may be visible or ultraviolet radiation or may be coherent light, X-rays, or electron beams, for example. Of course, the resist layer must be sensitive to the radiation utilized.

Referring to Figure 1B, the substrate and exposed resist layer is introduced to a silylating chamber 5, which is commonly a vacuum or reduced pressure chamber. The substrate and resist layer is heated by heating element 6 to a temperature of 180° C or higher. A silylating agent 7 is allowed to vaporize in a generating chamber 8 which is in communication with silylating chamber 5 via passage 9, for example. The gas state silylating agent therefore contacts the exposed resist layer 2. The silylating agent diffuses into the exposed portions of the mask layer and reacts with the polymer of this layer to replace a hydrogen atom with a silyl group. It is pointed out that only the uppermost portion of the resist layer is silylated and that the unexposed portions of the resist layer are not silylated. Examples of silicon compounds which can be used as the silylating agent include but are not limited to tetrachlorosilane, alkylhalosilanes, and arylhalosilanes. Specific examples are trimethylchlorosilane, dimethyldichlorosilane, methyltri- chlorosilane, trimethylbromosilane, trimethyliodosilane, and triphenylchlorosilane. Also, disilazanes may be utilized, such as, hexamethyldisilazane, heptamethyldisilazane, and hexaphenyldisilazane. The reaction of the silylating agent with the exposed resist layer must be closely controlled as to time and temperature of the reaction so that enough silicon is diffused and reacted with the resist polymer to prevent etching of the exposed resist in the subsequent plasma etch step while insuring that silicon does not diffuse sufficiently into the unexposed regions to prevent etching there. The temperature limits of this phase of the process are limited to below the temperature which will melt or seriously damage the resist material (or the semiconductor devices) and above the temperature required to vaporize the silylating agent. However, at temperatures of above 180° C it has been observed by the inventors of the instant invention that the silylating reaction occurs at an accelerated rate down to a few seconds which rate becomes increasingly difficult to control. Excess silicon, particularly silicon diffused into the unexposed resist portions but not chemically bonded to the polymer, may then be removed by evaporation, usually in a vacuum.

Referring now to Figure 1C, the substrate 1 with silylated resist layer 2 is exposed to a reactive ion etch, preferably a plasma oxygen 12 etch. This step of the process is also conducted in a chamber 11. The particulars of such a plasma oxygen etch are well known in the art and will not be detailed here. It is believed that in an oxygen plasma etch, oxygen combines with the silicon incorporated in the mask to form silicon dioxide which is highly resistant to the plasma etch. At any rate, the plasma etch effectively removes the portions 10 which have not been silylated. This dry etch process can be effected such that the etch is highly anisotropic and highly selective therefore allowing vertical lateral walls, high resolution, and minimum line and space width. If the exposed regions of the mask are not adequately silylated, the width of the remaining lines will be less than the width of the lines of the original mask 3. If the unexposed regions of the mask incorporate too much silicon by diffusion, the resulting lines of left in the resist layer will be wider than the lines of the original mask 3. Therefore to produce the desired pattern in the resist layer, it is necessary to accurately and reproducibly control the silylation step of the process.

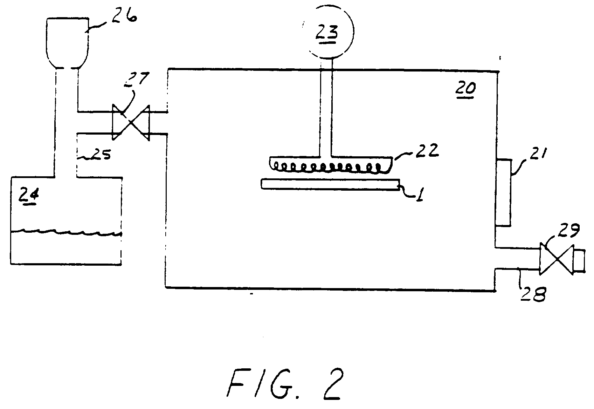

An apparatus for silylating the resist layer of a semiconductor substrate according to the instant invention will be explained with reference to Figure 2. A silylation chamber 20 includes a sealable port 21 through which a semiconductor wafer 1 with resist layer may be inserted into the chamber. A heating element 22 may be included in the chamber. Heating element 22 commonly includes a holder, not detailed, which holds the wafer 1 in communication with the heating element. Alternately, the heating element may be situated in the chamber but not in contact with the wafer to heat the contents of the chamber, or, the heating element may be outside the chamber to heat the chamber and its contents. Heating element 22 is connected to a temperature control 23 which controls the temperature of the wafer. Silylating agent generator 24 is in fluid communication with chamber 20 such as by passage 25. Generator 24 produces a silylating agent in gas phase. Pressurizing element 26 is also in fluid communication with silylation chamber 20 to provide a controllable pressure of at least one atmosphere (1013 hPa (760 torr)) in the chamber. Pressurizing element 26 may be, e.g., a source of pressurized inert gas, such as N2. A pressure controller such as control valve 27 controls the pressure in the chamber to a substantially constant preselected pressure at or above one atmosphere and in this case controls the introduction of the silylating agent to the chamber, also. Pressurizing element 26 may be, alternately, other means, such as a means to reduce the volume of the chamber. The pressure controller may include a pressure measuring device. An evacuation passage 28 and evacuation valve 29 is included to clear the silylation chamber.

In operation, a wafer having a radiation exposed resist layer such as that obtained in the prior art as shown in Figure 1A is introduced into the chamber 20. Note that it is also contemplated that the wafer can be exposed while in the chamber 20. Heating element 22 is turned on to heat the wafer to a preselected temperature such as 160 degrees C. A silylating agent is introduced to the chamber by opening control valve 27. Also, pressurizing element 26 is operated to provide a preselected pressure in the chamber of at least 1013 hPa (760 torr), for example, 1333 hPa (1000 torr). The preselected pressure is maintained by operation of control valve 27 in cooperation with evacuation valve 29. After a time period which can be easily determined by experimentation, for example, and which is not critical over a range for the operation according to the invention, the chamber is purged of the silylating agent via evacuation passage 28 by operation of evacuation valve 29.

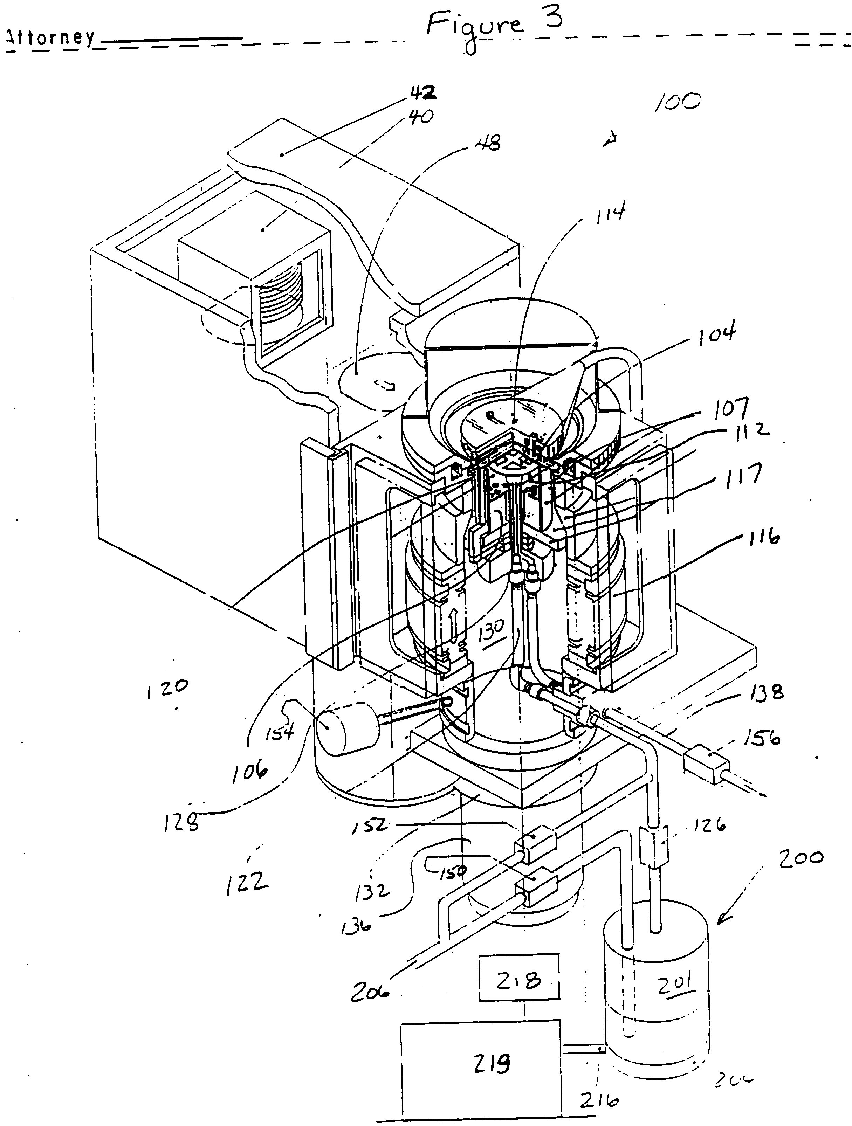

Referring to Figure 3, process module 100 uses a transfer arm (not shown) to transfer a wafer from a vacuum wafer carrier 40 to processing chamber 106. Process module 100 can be formed from any suitable material, for example, stainless steel or aluminum. Process module 100 can be either connected to central transfer chamber or can be physically separated from other process modules with the wafer 48 being transported between modules using vacuum wafer carrier 40. Process module 40 is similar to those disclosed in U.S. Patent Application Serial No. 074,448, filed July 16, 1987 which is hereby incorporated by reference.

Process chamber 106, where the actual processing is accomplished, is contained within process module 100. Process chamber 106 has vertical walls 107 which can be made from any suitable material, for instance, quartz. The vertical walls 107 form a cylinder about the vertical axis of process chamber 106. The bottom 117 of process chamber 106 is also be made from any suitable material, for instance, quartz. Heated substrate 114 forms the upper boundary of process chamber 106 and can be formed from any suitable material, for example, stainless steel.

In order to allow transfer of wafer and to subsequently contain wafer processing, vertical walls 107 are moved down for transfer and up for processing. Bellows 116 is attached to and moves vertical walls 107 up and down. When the vertical walls 107 are in the down position, the transfer arm (not shown) can transfer the wafer 48 from the carrier 40 through loadlock chamber 42 and into the process chamber 106 onto a plurality of fingers or pins 142. When moved to the up position, vertical walls 107 contact substrate 114 or an adjacent portion of module 100. A seal (not shown) can be provided at the location where the vertical walls 107 come into contact with heated substrate 114 or the adjacent portion of process module 100. When the chamber 106 is up, the fingers 120 move upward to place the wafer 48 into contact with the heated substrate 114.

Processing is accomplished in process chamber 106 through the use of a process gas distributor ring 104 which is located in the upper part of the process chamber 106 and heated substrate 114. The process gas distributor ring 104 which is formed from any suitable material, for instance, quartz, can supply a gas mixture to the process chamber 106 from pipe 122. Process gas distributor ring 104 is arranged about the vertical axis of chamber 106. The gas exits from the process gas distributor ring 104 through a plurality of openings 112 in the bottom of the process gas distributor ring 104. Pipe 122 extends from the mass flow controller 126 into chamber 130 through chamber bottom 117 and along the vertical axis of process chamber 106. The pipe 122 has, for example, a slip or a bellows 128 to accommodate the vertical movement of chamber 106, including the chamber bottom 117. Gas distributor ring 104 fits into an open end 138 of pipe 122. Gas distributor ring 104 is arranged concentrically within process chamber 106. Below chamber bottom 117 there is located chamber 130 which is connected to pump 132 and valve 136. Thus, a generally downward flow through chambers 106 and 130 is provided. Pump 132 and valve 136 provide the desired vacuum within the chamber 106. Wafer temperature can be controlled through the adjustment of power supplied heater power controller (not shown) to heated substrate 114. Heater power controller could be connected to process computer 218.

Processing module 100 allows the use of a vaporized liquid as source for the gas mixture being supplied to gas distributor ring 104. The gas mixture can be generated from suitable liquid source, for example, a silylating agent such as hexamethyldisilazane (HMDS) in gas generator 200. Gas generator 200 contains a chamber 201 for holding the liquid and a heater 204 for vaporizing the liquid. The power supplied to heater 204 is supplied through controller 214. The power to the heaters 204 is controlled using a temperature sensor 216 (for example, a thermocouple) which senses the temperature in the chamber 201 and provides a signal corresponding to controller 214. The temperature setpoint for the controller is set by the process computer 218 which is connected to the controller 214.

Process gas mixture flow rate and pressure is controlled by a series of gas supplies, mass flow controllers and a pressure sensor through the process computer 218. The gas mixture supplied to gas distributor ring 104 flows from the top of chamber 201 through mass flow controller 126 and then through pipe 122. Mass flow controller 126 receives signals from process computer 218. Process chamber 106 effluent is passed through exhaust line 138 through control valve 156 which also receives signals from process computer 218. In addition, process pressure is detected using pressure sensor 154, for instance a 10K manometer, which is in fluid communication with process chamber 106 and provides a signal corresponding to process pressure to process computer 218. Process pressure sensed by pressure sensor 154 is controlled through adjustment to both mass flow controller 126 and control valve 156 by process computer 218.

Processing module 100 also includes a purging capability. Purging of gas generator 200 can also be accomplished during purging of processing module 100. The purge is accomplished using a suitable purge gas, for example nitrogen, from purge gas source 206 supplied to the process chamber 106 through pipe 122 and mass flow controller 152 which is controlled through process computer 218. Purging of gas generator 200 is accomplished using the same purge gas source 206 through mass flow controller 150 which is controlled by process computer 218 the effluent passing from chamber 201 through mass flow controller 126, and pipe 122. Process chamber 106 effluent is drawn through valves 132 by vacuum pump 136.

Process module 100 which includes only one module and one vacuum load lock, but it can also be used in embodiments where a central handling chamber is combined with plural process modules 100 and one or more vacuum load lock chambers 42.

In operation, wafer 48 is first transferred to process chamber 106. Vacuum wafer carrier 40 is placed in loadlock 42. Loadlock 42 is pumped to a vacuum and the door (not shown) to the vacuum wafer carrier 40 is opened. When pressure in the loadlock 42 and process chamber 106 are equalized, an isolation port , not shown between loadlock 42 and process chamber 106 is opened. Bellows 116 is down and, with the opening of the isolation port, allows transfer to process chamber 106 of wafer 48. The actual transfer is accomplished using a transfer arm (not shown) which removes wafer 48 from the vacuum wafer carrier 40 and places it on fingers 120 in process chamber 106. The transfer arm is retracted from the process chamber 106 and the isolation port closes completing the transfer evolution.

The wafer 48 is placed in the processing position, i.e. in contact with the substrate 114 by the upward motion of bellows 116 which also closes process chamber 106.

The actual processing requires several operations. Heaters 140 are energized and the temperature as sensed by temperature sensor 216 of the gas generator 200 is raised to the setpoint, as determined by computer 218 and set by controller 214 and maintained there using heaters 140. Wafer temperature is established using heated substrate 114. The process gas mixture flow to process chamber 106 is initiated through mass flow controller 126 and the pressure in process chamber 106 is maintained, for example at 1013 hPa (760 torr), using a control valve in conjunction with mass flow controller 156 which are both controlled by the process computer 218 using pressure sensor 154. The desired gas mixture is then supplied via pipe 122 to process gas distributor ring 104 and to the face of the wafer 48.

After the completion of the processing, process gas flow is stopped, and all the heater power is shut off. A suitable purge gas, such as nitrogen, is applied to process chamber 106 from purge gas source 206 through mass flow controller 152. When the purge is complete and the purge gas flow is stopped by mass flow controller 152, the bellows 116 moves downward thereby opening the process chamber 106 as described above, and allowing the transfer arm to enter the process chamber 106 and retrieve wafer 48 as described above. The transfer arm then returns the wafer 48 to the vacuum wafer carrier 40 in chamber 42 as described above.

The inventor also comprehends in this invention other wafer transfer mechanisms other than a vacuum wafer carrier 40, as shown. Wafers could be provided to loadlock 42 at atmospheric or other pressures.

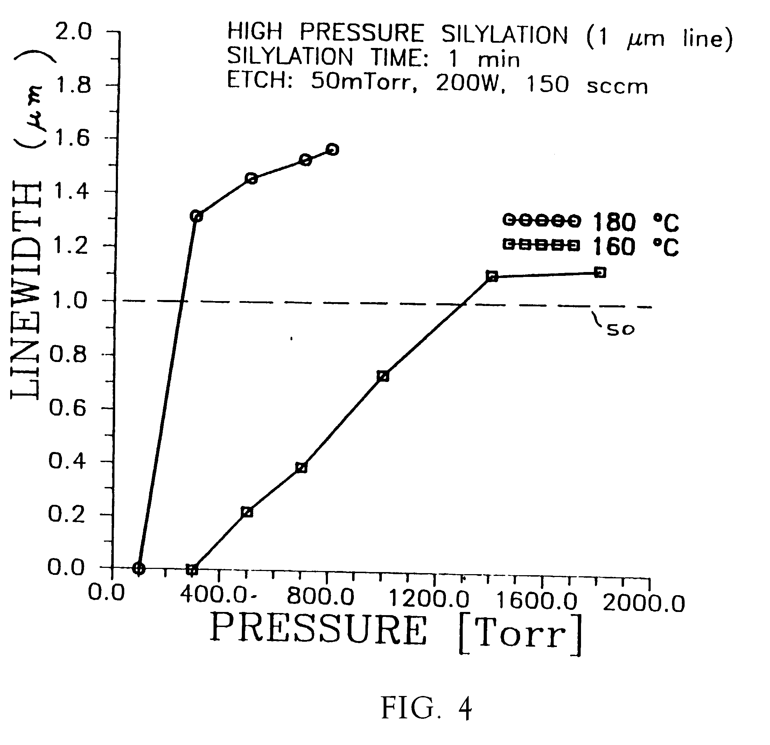

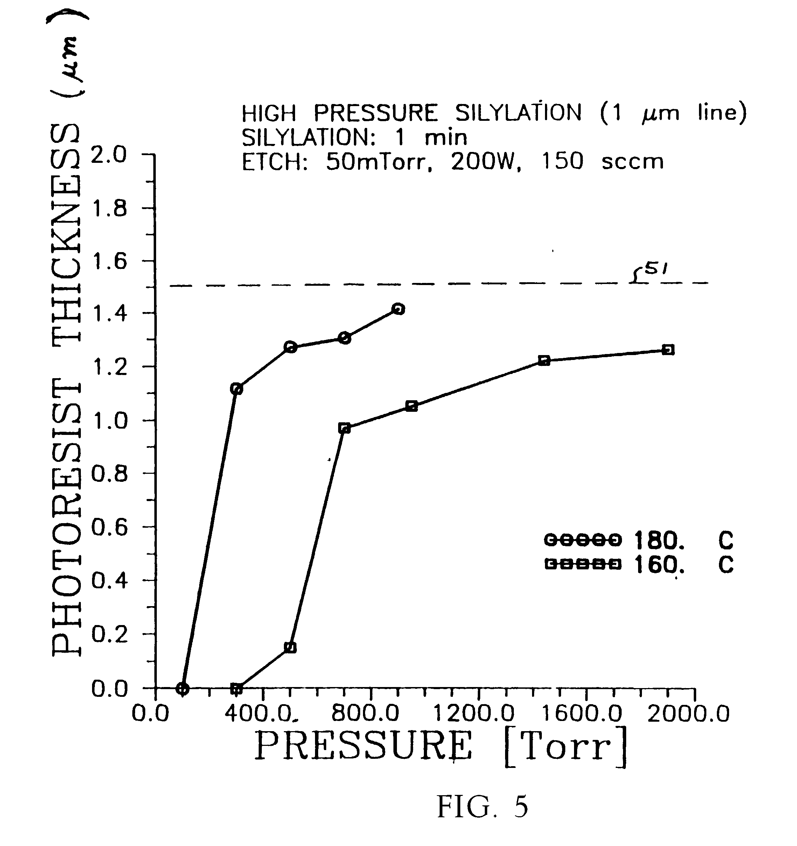

Experimental results have quantitatively shown that silylation of a resist layer at pressures 1013 hPa of (760 torr) and above produce superior and unexpected results over silylation conducted at lesser pressures. Referring to Figures 4 and 5, both graphs were produced using wafers having the photosensitive resist layer exposed by ultraviolet radiation through a mask having 1 micron linewidths. Using hexamethyldisilazane (HMDS) as the silylating agent pressurized by N2 for a period of one minute at temperatures of 160° and 180° C, wafers were silylated at various pressures from 133 to 2400 hPa (100 to 1800 torr). The wafers were then plasma oxygen etched at 6.6 Pa (50 mTorr) and 200 W with a gas flow of 150 sccm. The width and thickness of the resulting lines in the resist layer were then measured. Referring to Figure 4, it can be seen that for a silylation temperature of 180° C, the width of the line rises from zero to about 1.3 microns while the pressure changes only from 133 to 1866 hPa (100 to 1400 torr). In Figure 4, dotted line 50 represents the desired linewidth, 1 micron, given the original mask linewidth of 1 micron. It is evident that a silylation temperature of 180° C is less acceptable for controlling the silylation rate due to the approximated slope of the curve. A very small change in pressure causes a large change in the degree of silylation as represented by the linewidth. A change ( P) of 266 hPa (200 torr) increases the silylation rate from unacceptably low (0.0 micron linewidth or complete under silylation) to unacceptably high (1.2 micron linewidth or 20over silylation). From a time perspective it is clear that for any pressure over 399 hPa (300 torr), correct silylation time must be considerably less than 1 minute. Such a short time period also would be hard to control. A small change in silylation time would lead to a relatively large change in resulting linewidth (extent of silylation). A 160° C silylation temperature, on the other hand, results in a considerably more easily controllable process as indicated by the slope of this approximated curve in Figure 4. For example, in the area of the curve bounding the desired 1 micron linewidth, a change ( P) of 53 hPa (40 torr) results in only about .035 microns change in the linewidth. From a time perspective, however, it is apparent that for pressures of less than 1013 hPa (760 torr), which are almost exclusively used in the prior art, a silylation time of considerably longer than one minute would be required for acceptable linewidth (degree of silylation) if a silylation temperature of 160° C is used. The inventors have found, in fact, that to use a 160° C silylation temperature or less at substantially less than 1013 hPa (760 torr)silylation pressure, an considerably longer time would be required to achieve the desired linewidth (degree of silylation).

Figure 5 depicts the result of measurements of the photosensitive resist layer thickness in exposed regions of the resist after plasma oxygen etch using the same etch process parameters and a one minute silylation time using wafer having the same photosensitive resist material and using the same silylating agent (HMDS) as used in Figure 4. The resist thickness before processing was 1.5 microns for all wafers. Therefore, it is desired in the best case that as close as practical to 1.5 microns of resist material remains after etching. The desired thickness is graphically represented by dotted line 51. Again, from Figure 5, it is apparent that increasing silylation pressure increases the silylation rate in the exposed resist material since in each case for a one minute silylation time, a greater thickness of the resist layer remains as the silylation pressure incrementally is increased. Also indicated by Figure 5, is confirmation that decreasing the silylation temperature results in a process which is effectively controllable over a broader range of silylation pressures.

The inventors have concluded and verified that conventional low pressure silylation is not as controllable to obtain desired etch patterns as high pressure silylation (above 1013 hPa (760 torr)) and, further, that higher pressure silylation allows the more effective utilization in terms of time, controllability, and satisfactory etched resist patterns of silylation temperatures less than 180° C (preferably about 160° C or less). Although the mechanisms of high pressure silylation are not completely understood it has been clear to the inventors from substantial testing and experimentation that use of higher pressures and lower temperatures in the process than practiced in the prior art results in a substantially more controllable, faster, and more usable process. Concentration levels of the silylating agent has been experimentally eliminated as a substantial source of the observed silylation rate change as pressure is increased.

Although silicon examples are shown herein, wafers made of other materials such as germanium, etc. can also be etched. The wafers can be comprised of many different configurations, for example, a single piece of crystals material or small crystals located on a larger substrate. Although wafers such as 48 are disclosed herein, other types of flat workpieces could be used with the techniques disclosed herein.

The result of processing the wafer 48 can be electronic devices, for example, integrated circuits or discreet semiconductor devices. Once the processing is complete, the wafers are divided into devices. The circuits and devices are enclosed into packages, for example, as shown in U. S. Patent 4,465,898 issued to Orcutt, et al., on August 14, 1984 and 3,439,238 issued to Birchler, et al. on April 15, 1969. These packages are then utilized in the construction of printed circuit boards. The printed circuit boards which cannot operate without the integrated circuits and devices to perform their intended functions, other required electrical components within computers, photocopiers, printers, telecommunication equipment, calculators and all of the other electronic equipment which are essential ingredients of the electronic and information age. Thus, electronic equipment can not function without these circuits and devices.

The present application describes features which serve to provide further advantages.

The present invention advantageously provides better control of the photolithographic development process.

It is yet another advantage of the present invention that it provides for photolithographic development in a low particulate environment thereby increasing the yield.

This invention allows a faster silylation rate and thus can increase the manufacturing throughput.

This invention allows the performance of several processing steps while maintaining a wafer under a vacuum and in a face down configuration in the same or another similar chamber.

Having described the invention in connection with certain specific embodiments thereof, it is to be understood that farther modifications may now suggest themselves to those skilled in the art, but is intended to cover all such modifications as fall within the scope of the appended claims.

## Claims

1. A process of patterning a photoresist layer (2) on a semiconductor wafer substrate (1) comprising:
(a) selectively exposing portions of said photoresist layer (2) to radiant energy;
(b) then exposing said radiation exposed photoresist layer (2) to a silicon-containing material in gas form, at a temperature above ambient but no greater than about 160°C, and at a pressure between 1066 and 2666 hPa, for a time sufficient to cause silylation of only the surface portion of the radiation exposed photoresist (2); and
(c) then treating the radiation exposed and silylated photoresist layer (2) with a plasma etchant, to develop a pattern by removing those portions of said photoresist layer (2) which have not been silylated.

2. A process as in claim 1 wherein said photoresist layer (2) comprises a phenolic polymer and a photosensitive resin.

3. A process as in claim 1 wherein said silicon-containing material comprises hexamethyldisiazane.

4. A process as in claim 1 wherein the pressure is maintained by adding a pressurized inert gas with the silicon-containing material.

5. A process as in claim 1 wherein said plasma etchant comprises oxygen.

## Patentansprüche

1. Verfahren zum Strukturieren einer Photoresistschicht (2) auf einem Halbleiterscheibensubstrat (1), bei welchem
(a) Abschnitte der Photoresistschicht (2) selektiv einer Strahlungsenergie ausgesetzt werden;
(b) die der Strahlung ausgesetzte Photoresistschicht (2) dann bei einer Temperatur über der Umgebungstemperatur, jedoch nicht größer als 160°C, und einem Druck zwischen 1066 und 2666 hPa einem siliciumhaltigen Material in Gasform für eine Zeitdauer ausgesetzt wird, die ausreicht, nur die Silylierung des Oberflächenabschnitts des der Strahlung ausgesetzten Photoresists (2) zu verursachen; und
(c) die der Strahlung ausgesetzte und silylierte Photoresistschicht (2) dann mit einem Plasmaätzmittel zu behandeln, damit durch Entfernen derjenigen Abschnitte der Photoresistschicht (2), die nicht silyliert worden sind, eine Struktur zu entwickeln.

2. Verfahren nach Anspruch 1, bei welchem die Photoresistschicht (2) ein Phenolpolymer und ein lichtempfindliches Harz umfaßt.

3. Verfahren nach Anspruch 1, bei welchem das siliciumhaltige Material Hexamethyldisilazan umfaßt.

4. Verfahren nach Anspruch 1, bei welchem der Druck durch Hinzufügen eines unter Druck gesetzten inerten Gases mit dem siliciumhaltigen Material aufrechterhalten wird.

5. Verfahren nach Anspruch 1, bei welchem das Plasmaätzmittel Sauerstoff umfaßt.

## Revendications

1. Procédé destiné à configurer une couche (2) d'agent photorésistant placée sur un substrat (1) de plaquette en semi-conducteur comprenant :
a) l'exposition sélective de tronçons de la couche (2) d'agent photorésistant à une énergie rayonnante ;
b) puis l'exposition de ladite couche (2) d'agent photorésistant soumise au rayonnement à un matériau contenant du silicium sous forme de gaz, à une température supérieure à la température ambiante mais non supérieure à environ 160° C, et sous une pression comprise entre 1066 et 2666 hPa, pendant une durée suffisante pour provoquer la silylation du tronçon de surface d'agent photorésistant (2) seulement exposé au rayonnement ; et
c) puis le traitement de la couche (2) d'agent photorésistant ayant subi la silylation et ayant été exposée au rayonnement avec un réactif d'attaque en plasma, pour développer un dessin en retirant les tronçons de la couche (2) d'agent photorésistant qui n'ont pas subi la silylation.

2. Procédé selon la revendication 1, dans lequel la couche (2) d'agent photorésistant comprend un polymère phénolique et une résine photosensible.

3. Procédé selon la revendication 1, dans lequel ledit matériau contenant du silicium comprend de l'hexaméthyldisilazane.

4. Procédé selon la revendication 1, dans lequel la pression est maintenue en ajoutant un gaz inerte sous pression au matériau contenant du silicium.

5. Procédé selon la revendication 1, dans lequel ledit réactif d'attaque en plasma comprend de l'oxygène.
